Europäisches Patentamt

European Patent Office

Office européen des brevets

(11) Publication number: **0 448 942 A1**

# EUROPEAN PATENT APPLICATION

(21) Application number: 91101853.9

(51) Int. Cl.5: **H01L 23/495**

(22) Date of filing: **11.02.91**

(30) Priority: **15.03.90 US 493654**

(43) Date of publication of application:
**02.10.91 Bulletin 91/40**

(84) Designated Contracting States:
**DE FR GB**

(71) Applicant: **International Business Machines Corporation**
**Old Orchard Road**
**Armonk, N.Y. 10504(US)**

(72) Inventor: **Conru, H. Ward**
**15 Essex Highlands**
**Essex Junction, Vermont 05452(US)**
Inventor: **Starr, Stephen George**
**53 Foster Road**
**Essex Junction, Vermont 05452(US)**

(74) Representative: **Klocke, Peter, Dipl.-Ing.**
**IBM Deutschland GmbH Patentwesen und Urheberrecht Schönaicher Strasse 220**
**W-7030 Böblingen(DE)**

(54) **Semiconductor package.**

(57) A lead frame (10) having a plurality of metallic conductors (16) with each conductor having a coined or stamped region (40) near its proximal end (16b) but spaced therefrom (41) to provide pressure points (41) to assure substantial even joining of the conductor (16) to semiconductor chip (12) via an insulative adhesive medium (11). The lead frame (10), when mounted on the active face (15) of a semiconductor chip (12), has wires (24) connecting terminals (14) on the major active surface (15) of the semiconductor chip (12) to the lands (40) on selected lead frame conductors (16). The lead frame (10) on the semiconductor chip (12) and the wires (24) which connect the semiconductor chip terminals (14) to the lands (40) of selected lead frame conductors (16) are then encapsulated with a suitable insulative material (21) to form a semiconductor module or package (20).

FIG.4

This invention relates to an improved conductor assembly comprising uniquely formed lead frame conductors used to attach a semiconductor chip to a socket or pc board.

U.S. Patent 4,862,245 describes a technique for positioning and fixing leads to a semiconductor chip prior to encapsulation of the chip in a protective coating by extending the lead frame over the surface of the chip.

During the forming operation for creating the lead frames used with such encapsulated devices the surface of the lead frame fingers become crowned, i.e. the covers become quite rounded, and hemispherical. It has been found that it is difficult to bond wires to these crowned surfaces. Thus, during the operation where wires are being bonded between the pads on the chip and the lead frame as taught in U.S. Patent 4,862,245, defects can occur.

It is an object of this invention to provide an improved lead frame conductor with an improved land or wire bonding area thereon.

These and other objects of the present invention as claimed are provided by a lead frame provided with improved lands for contacts to a semiconductor chip. The lead frame comprises a plurality of figured conductors in which the proximal end of each conductor is arranged in a desired pattern having fixed spacing and is provided with a land region suitable for bonding wires extending from a semiconductor chip thereto. The distal ends of the conductors fan out into a selected configuration and are adapted to connect with electrical voltage and external signal and voltage lines. Each lead frame conductor of the invention has one end coined to form a land or wire bonding area and each is arranged to extend over and be joined to the surface of a chip.

One advantage of the invention in an improved lead frame conductor that can be fully joined to an insulative layer.

A further advantage of the invention is a plastic encapsulated semiconductor package which when connected with lead frame members provided with improved lands or wire bonding areas has enhanced electrical and thermal coupling between the underlying semiconductor chip and the lead frame as well as improved mechanical interlocking of the lead frame to the encapsulant.

These and other objects, features and advantages of the invention will become more apparent from the following particular description of the preferred embodiment of the invention as illustrated in the accompanying drawings, in which:

Fig. 1 · is an exploded representation of one embodiment of the present invention showing the spacial relationship between the chip, the insulative layer and the lead frame assembly of the present invention;

Fig. 2 is a partially broken away view of a semiconductor chip, having the lead frame of the present invention; mounted on a major face thereof;

Fig. 3 is a partial sectional view of lead frame conductors or fingers which have been coined on their very tips showing the lead frame fingers during bonding of the lead frame via the insulative layer to a semiconductor chip surface by a thermode; and

Fig. 4 is a partial sectional view of lead frame fingers coined in accordance with the preferred embodiment of the present invention showing the lead frame fingers during bonding of the lead frame via the insulative layer to the surface of a semiconductor chip by a thermode.

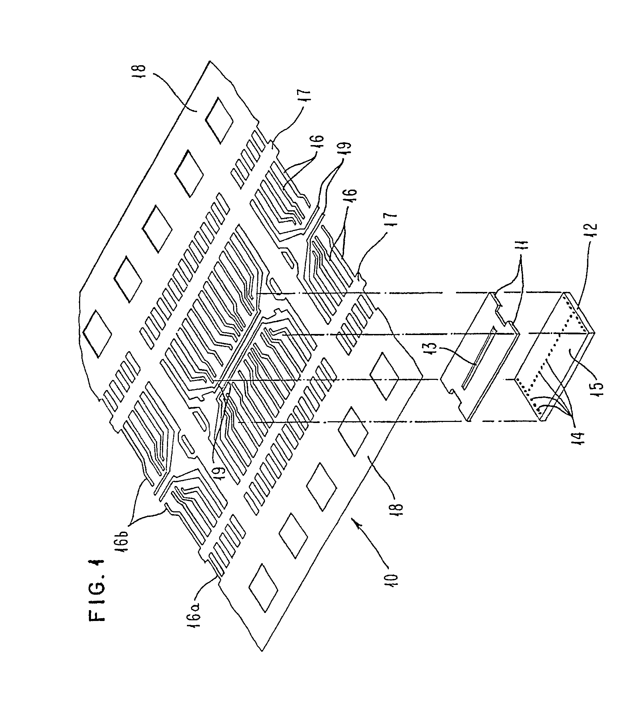

Fig. 1 is an exploded view of one embodiment of the invention and shows the spacial relationship of the lead frame 10, a shaped insulating layer 11 and a semiconductor chip 12 arranged to be bonded together. The lead frame 10 is produced from metal sheet stock and is provided with a plurality of conductors 16 whose distal ends 16a are held in place by cross bars 17 and selvage strips 18. The proximal ends 16b of the conductors float free. The outmost conductors on each side of the lead frame can be interconnected by extended bus bars 19. These bus bars are arranged to be generally parallel to the centrally disposed row of chip pads 14. The sheet stock in which the lead frame is formed is preferably copper or aluminum although other alloys or metals are readily used in the art. The term lead frame as used herein is well known in the art and the material thicknesses, strength, etc. of such lead frames is well known and the use of this term lead frame is all that is necessary to purchase such items from a number of commercial sources. In the art, the term lead frame means a metal structure formed from metal sheet stock and of a sufficient size and strength to meet specific mechanical strength requirements. Typically, the conductors extending from the package for using such a lead frame are 127 $\mu$m to 381 $\mu$m (0.005 to 0.015 inches) thick and approximately 203 $\mu$m to 381 $\mu$m (0.008 to 0.015 inches) wide and of such strength as to be successfully put into a socket or secured to surface mounted printed circuit boards without distortion and without buckling due to slight misalignment. Such lead frames are extensively used and known in the semiconductor integrated circuit art and manufactured by a number of commercial suppliers.

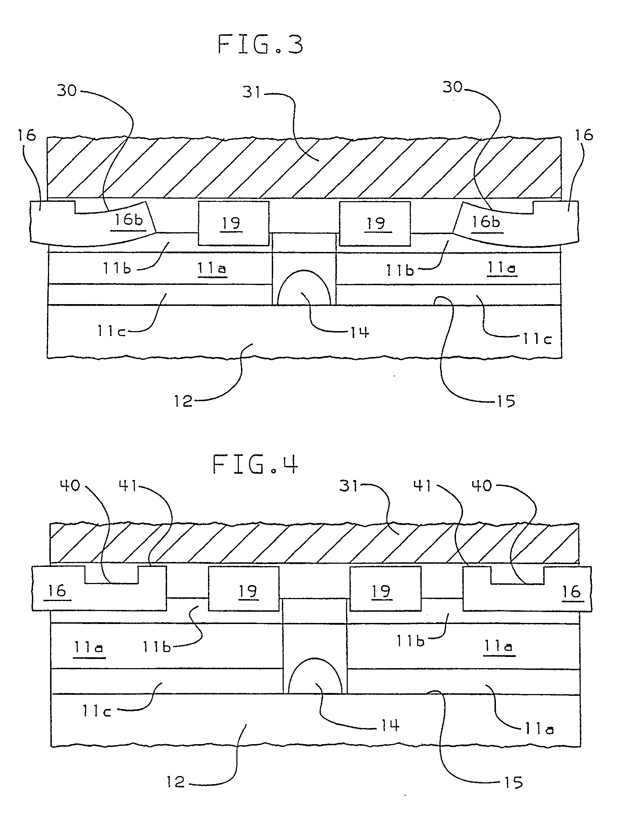

The insulating layer 11 can be a single piece, as shown, with a centrally deposed opening 13 or can be made in as two separated lobes as shown in U.S. Patent 4,862,245. This insulating layer 11 as shown in Figs. 3 and 4 typically is formed of an insulative backing or film usually a 25.4 $\mu$m (0.001 inch) thick polyimide film 11a coated on both sides with 20.3 $\mu$m (0.0008 inch) thick adhesive layers 11b and 11c. The film should have a melting temperature above 275°C and not contain ionizable species such as halides or active metals such as sodium. One such polyimide suitable for such a purpose is sold by E. I. DuPont De Nemours & Co. under the tradename KAPTON.

Suitable adhesives are butyral phenolic, an epoxy, or an acrylic.

The chip 12 has a centrally arranged row of pads 14 on a face 15 thereof. Additional pads can be arranged on the extreme ends of the chip as shown.

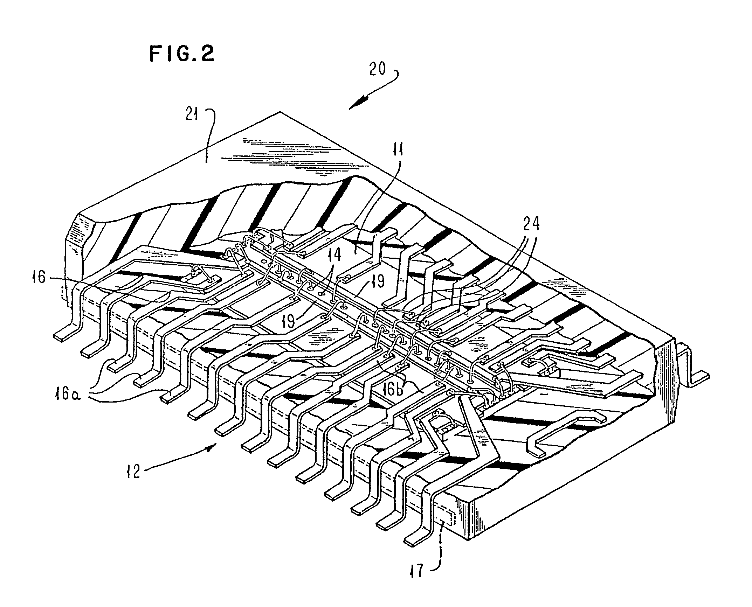

Fig. 2 shows a completed package 20 employing the present invention in which part of the encapsulating material 21 has been removed for clarity and to show the internal construction and arranging of the lead frame 10, insulator 11 and semiconductor chip 12 after assembly. After encapsulation the lead frame selvage strips 18 and the cross bars 17 shown in Fig. 1 are removed and the distal ends 16a of conductors 16 which extend beyond the package may be formed as required.

As will be shown in greater detail in Fig. 3, the proximal ends 16b of the lead frame conductors, which are adjacent to the bonding pads on the semiconductor chip, are formed or coined to provide lands of uniform area and thicknesses to provide better bonding areas for the gold wires 24, connected between the chip pads 14, and the leads 16.

One embodiment of the coined lands on the proximal ends 16b is shown in greater detail in Fig. 3. In this Fig. 3, the extreme ends 16b of the lead frame conductor 16 are stamped to form uniformly flat lands 30 for the wire bond attachments. The stamping or coining operation causes the proximal end 16b of each lead 16 to be substantially reduced to a thickness which can be up to one-half of the original thickness of the lead. Once the ends 16b of each lead 16 is so stamped or coined the lead frame conductors 16 and the bus bars 19 are bonded to the major face 15 of the underlying semiconductor chip 12. This is accomplished by placing the adhesive coated insulative film 11a between the lead frame and the chip and then positioning a thermode 31 over the assembly comprising the chip 12, the coated insulator 11, and the lead frame conductor 16 and forcing the lead frame conductors 16 and the bus bars 19 into the upper adhesive surface 11b.

The thermode 31 heats and applies pressure to the lead frame conductor 16. The pressure and heat applied by the thermode partially melts the underlying adhesive layers 11a and 11b beneath the lead frame conductors and causes the film to bond to the lead frame and the chip surface 15. As the adhesive layer 11b melts beneath the conductors 16 they, the conductors, are forced into the upper adhesive layer 11a. When a thermode such as is shown in Fig. 3 is used the coined tips of the leads 16 are not in direct contact with the thermode and they can become bent upwards by the force of the underlying adhesive as shown in Fig. 3. Such deformed bond areas causes problems when the wires 24 are bonded thereto. Specifically, the bending and distortion of these lands is a direct cause of wire bond yield loss and poor wire bond reliability. These deformed lands are not desirable.

Fig. 4 shows the preferred embodiment of the present invention and depicts in cross section lead frame conductors 16 which are coined to provide bonding lands 40 separated from the extreme tip of the conductors 16 by small islands 41 of uncoined material, so that flat thermodes can be used to bond the lead frame conductors to the surface of the chip via the layers 11, 11a and 11b without encountering the bending and distortion of the tips of the leads as was discussed in conjunction with Fig. 3 above.

In Fig. 4, the lead frame conductors 16 have formed near its proximal end coined lands 40 which are spaced from the extreme tips of each lead frame conductor 16 by a small island 41 of uncoined material. These islands retain their original thickness and thus when the thermode 31 is brought into contact with the lead frame conductors 16, the thermode 31 will heat and apply the same pressure to the tips of the lead frame conductors 16 as it applies to the remainder of each lead frame conductor so as to evenly force the entire length of each lead frame conductor into the adhesive layer 11b. These islands 41 thus provide pressure points to assure that the thermode 31 applies to each lead frame tip, sufficient pressure and heat such that bending of the tip or the coined lands does not occur.

## Claims

1. A lead frame (10) for providing contacts to a semiconductor chip (12) comprising:

   a plurality of conductive fingers (16) arranged in a desired pattern adapted to be bonded to selected contacts on a semiconductor chip,

   the proximal end (16b) of said conductive fingers arranged in a fixed spacing and provided with a coined bonding region (40) adapted to provide a wire bond contact area for a wire adapted to connect to pads on a semiconductor chip, and

the distal ends (16a) of said conductive fingers fanning out and adapted to connect with signal and voltage lines,

characterized by the coined bonding region on each of said proximal ends, of said fingers, being separated from the end of said fingers by an uncoined region (41).

2. A lead frame of claim 1 wherein said coined bonding regions are formed with a thickness less than the full thickness of the remainder of the conductors.

3. An encapsulated semiconductor module (21) comprising:

a semiconductor chip (12) having a major surface with terminals thereon disposed within an encapsulating material;

a lead frame comprising a plurality of self supporting unitary, discrete, and continuous lead frame conductive fingers (16) formed of metal sheet stock extending over said major surface of said chip at spaced locations from said terminals,

the proximal end (16b) of said conductive fingers arranged in a fixed spacing and provided with a coined bonding region (40) adapted to provide a wire bond contact area, and

the distal ends (16a) of said conductive fingers fanning out from said chip and said encapsulating material, and adapted to connect with signal and voltage lines,

characterized by the coined bonding region on each of said proximal ends, of said fingers, being separated from the end of said fingers by an uncoined region, and

discrete electrical wire means (24) bonded to the coined bonding regions on said conductive fingers and said terminals and electrically connecting said conductors to said terminals.

4. An encapsulated semiconductor module (21) comprising;

a semiconductor chip (12) having terminals thereon disposed within an encapsulating material;

a lead frame comprising a plurality of self supporting unitary, discrete, and continuous lead frame conductors (16), and formed of metal sheet stock, extending over said chip and positioned to avoid contact with said terminals,

the proximal ends (16b) of said conductors arranged in a fixed spacing, adjacent said terminals and each proximal end is provided with a coined bonding region adapted to provide contacts to the semiconductor chip,

the distal ends (16a) of said conductors fanning out from said chip and cantilevered out of the encapsulated material, and adapted to connect with signal and voltage lines,

characterized by the coined bonding region on each of said proximal ends, of said fingers, being separated from the end of said fingers by an uncoined region,

electrically insulating material (11) disposed between said chip and said plurality of lead frame conductors, and attached to said plurality of lead frame conductors and to said semiconductor chip, and

discrete electrically conducting wire means (24) bonded to a coined bonding region on a conductor and to respective terminal on said chip to electrically connect the conductor to the terminal.

5. The module of claim 4 wherein said insulating material comprises a polyimide film coated with adhesive layers.

6. The module of claim 3 or 4 wherein there is further provided said lead frame linear bus bar parallel to said chip terminals and lying between said proximal ends of said conductive fingers or conductors, respectively, on said terminals.

7. The module of claim 6 wherein said bus bars are provided with coined bonding regions.

8. The module of any one of the preceding claims 3 to 7 wherein said coined bonding regions are formed with a thickness less than the full thickness of the remainder of the conductors.

FIG. 1

# FIG.2

EP 0 448 942 A1

# FIG.3

# FIG.4

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| D,Y | US-A-4 862 245   (R. PASHBY ET AL.)<br>* the whole document * | 1-6,8 | H 01 L 23/495 |
| Y | PATENT ABSTRACTS OF JAPAN vol. 013, no. 110 (E-728) 16 March 1989,<br>& JP-A-63 283053 (NEC CORP.) 18 November 1988,<br>* the whole document * | 1-6,8 | |
| A | PATENT ABSTRACTS OF JAPAN vol. 013, no. 062 (E-715) 13 February 1989,<br>& JP-A-63 250849 (HITACHI CABLE LTD.) 18 October 1988,<br>* the whole document * | 1-4,8 | |
| P,A | PATENT ABSTRACTS OF JAPAN vol. 014, no. 320 (E-950) 10 July 1990,<br>& JP-A-02 106059 (HITACHI CABLE LTD.) 18 April 1990,<br>* the whole document * | 1-4,8 | |
| A | PATENT ABSTRACTS OF JAPAN vol. 011, no. 244 (E-530) 08 August 1987,<br>& JP-A-62 054945 (SUMITOMO ELECTRIC KOGYO KK.) 10 March 1987,<br>* the whole document * | 1-4,8 | |

TECHNICAL FIELDS
SEARCHED (Int. Cl.5)

H 01 L

The present search report has been drawn up for all claims

| Place of search | Date of completion of search | Examiner |
|---|---|---|
| The Hague | 24 June 91 | ZEISLER P.W. |